# EUROPEAN PATENT APPLICATION

(11) **EP 4 276 915 A1**
(43) Date of publication of application: **15.11.2023**
(21) Application number: 22172638.3
(22) Date of filing: 10.05.2022
(51) Int. Cl.: H01L 31/042

(54) **PHOTOVOLTAIC MODULE WITH SHADE-TOLERANT CELL-STRING LAYOUT**

(71) Applicant: Solarnative GmbH, 65934 Frankfurt (DE)
(72) Inventor: Oldenkamp, Hendrik, 34320 Söhrewald (DE); Mattheis, Julian, 65934 Frankfurt (DE)
(74) Representative: Schulz Junghans Patentanwälte PartGmbB

(57) **Abstract**

The present invention relates to a solar module zone (110) of a solar module (100), the solar module zone (110) comprising an array of solar cells (101,201) arranged in pairs of substrings (104) along columns of the array, wherein
- each substring (104) comprises a plurality of solar cells (101,201) electrically connected in series along the column the substring (104) extends in,
- each pair of substrings (104) comprises two substrings (104) that extend along the columns, particularly adjacent columns, and that are electrically connected in series, and wherein all pairs of substrings (104) are electrically connected in parallel,
- each pair of substrings (104) comprises a positive and a negative end terminal (105) for connecting the pair of substrings (104) to a plus and a minus pole of the solar module (100), wherein the negative and the positive end terminals (105) of each pair of substrings (104) are located adjacent to each other in an end terminal-connecting portion of the solar module zone(110), particularly solar module (100), such that the end terminals (105) of the pairs of substrings (104) form a sequence of end terminals (105) along the columns having a sequence of polarities,
characterized in that the sequence of polarities of the end terminals (105) comprises at least two changes of polarity of adjacent end terminals (105).

The invention also relates to a solar module (100) comprising such a solar module zone (110) as well as a photovoltaic system (111).

## Description

### Area of the invention

The invention on hand relates to the interconnection of solar cells in photovoltaic modules (also called solar panels) and the objective to make the solar panels more resilient against partial shading, such that a photovoltaic module with shade-tolerant cell-string layout is obtained.

### State of the art

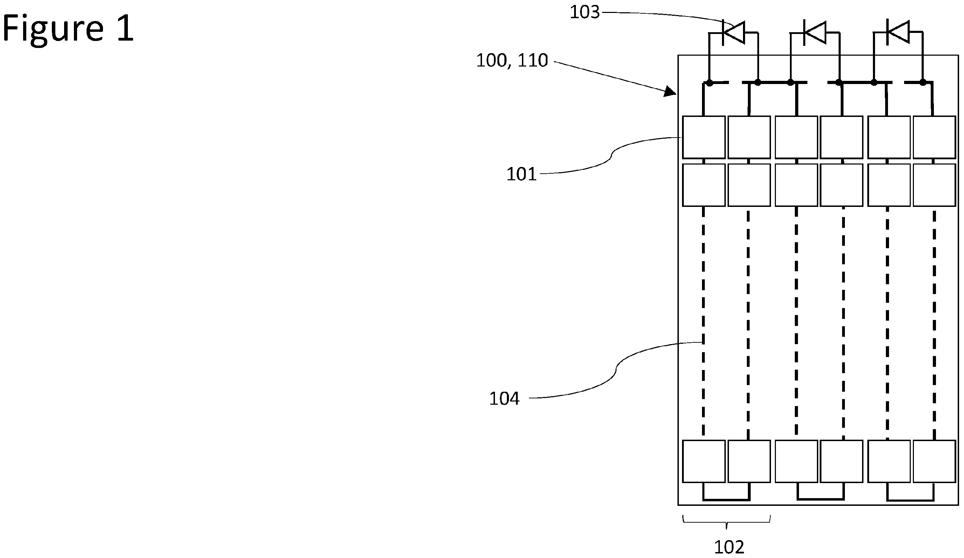

According to the state of the art, solar cells 101 are interconnected to solar module zones of solar modules 100 as displayed in Figure 1. The solar cells 101 are interconnected with solder wires that connect the front side of one solar cell 101 with the rear side of the next solar cell 101. The solar cells 101 are thereby connected in series.

Typically, all solar cells 101 of a PV module are interconnected in series. Typical commercially available solar modules 100 consist of 60 or 72 solar cells 101. The layout is normally 6 x 10 or 6 x 12 solar cells 101, i.e. the solar cells are arranged in an array of 6 columns and 10 to 12 rows. Such an array may be summarized in a solar module zone 110 of a solar module 100. A solar module 100 can comprise multiple solar module zones 110, particularly multiple identical solar module zones 110. The individual solar module zones 110 may be electrically connected but they may also form independent electrical circuits, respectively. In case of an electrical connection between different solar module zones 110 of a solar module 100, they may be connected in series or in parallel. Each solar cell 101 has a short-circuit current of -10 A and an open-circuit voltage of -0.7 V. The total solar module 100 has the same current, and the sum of the individual solar cell voltages, i.e. -42 V. The solar cells 101 are typically grouped into three so-called strings 102 with 2 x 10 or 2 x 12 cells comprising a pair of substrings 104 connected in series, according to Figure 1. Each substring 104 is connected to a bypass diode 103 in an anti-parallel fashion. In case a substring 104 is shaded, the bypass diode 103 becomes active and bypasses the shaded substring 104 so that it does affect the performance of the rest of the solar cells 101, which are connected in series.

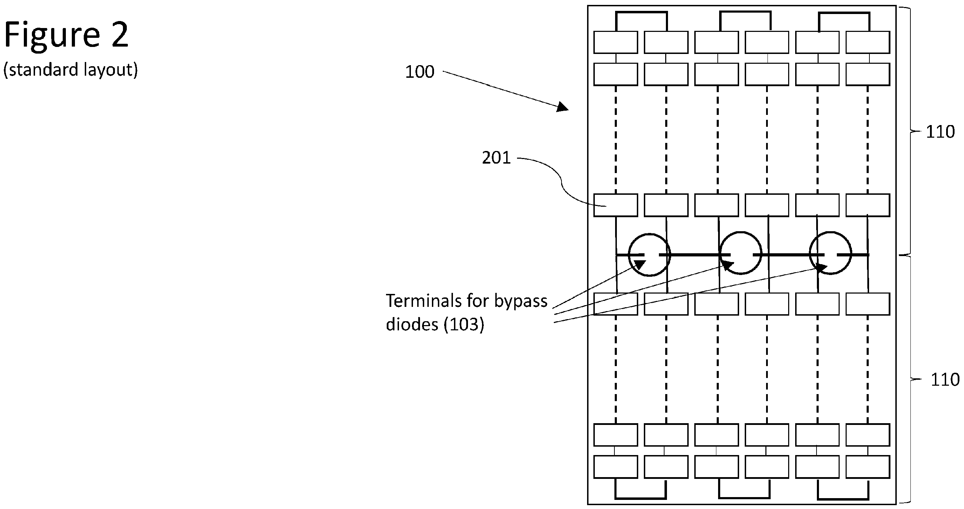

Figure 2 displays a solar module 100 with so-called half-cut solar cells 201 as known from EP 3799245 A1. The solar cells are cut in half to reduce the current generated by them. By doing so, the losses in the solar module 100 can be reduced considerably compared to the layout with full solar cells 101 in Figure 1. This approach has become the state-of the art in recent years.

When using half-cut solar cells 201, the layout of a module would become 6 x 20 or 6 x 24 solar cells. However, such a layout would lead to large reverse bias voltage of shaded solar cells in a partial shading situation, which could lead to overheating of the solar cells 101,201 and could damage the solar cell 101,201 and the solar module 100. Typical solar cells 101,201 cannot withstand reverse bias voltages larger than -12 or -13 V, therefore, the number of solar cells 101,201 per substring 104 is limited to 20-24 solar cells 101,201. A layout in accordance with Figure 1 would lead to 40-48 solar cells 101,201 per substring 104.

Therefore, in Figure 2, the solar module 100 is split into a lower and an upper solar module zone 110, which are connected in parallel. With this layout, the number of solar cells 101,201 per substring 104 is again only 10 or 12. In the following, this layout will be referred to as "standard layout"

The standard layout has an additional advantage and that is the power output in partial shading situations. Depending on the shading situation, the layout in Figure 2 can deliver significantly more energy (normalized to the solar module power) than the layout in Figure 1.

However, the disadvantage is that the assembly effort is increased significantly, and the junction boxes for connecting the solar module cables are in the center and have to be split into three separate boxes with one bypass diode 103 each. Moreover, the solar module length is increased by 1-2 cm, which reduces the solar module efficiency as being defined by the solar module power divided by the solar module area, by roughly 1-2 %.

WO 2021098895 A1 describes a module layout with long substrings of 20 solar cells. The reverse bias of the solar cells is controlled at an uncritical level with the input unit of a micro-inverter or power optimizer. WO 2021098895 A1 uses three separate substrings which are each controlled individually.

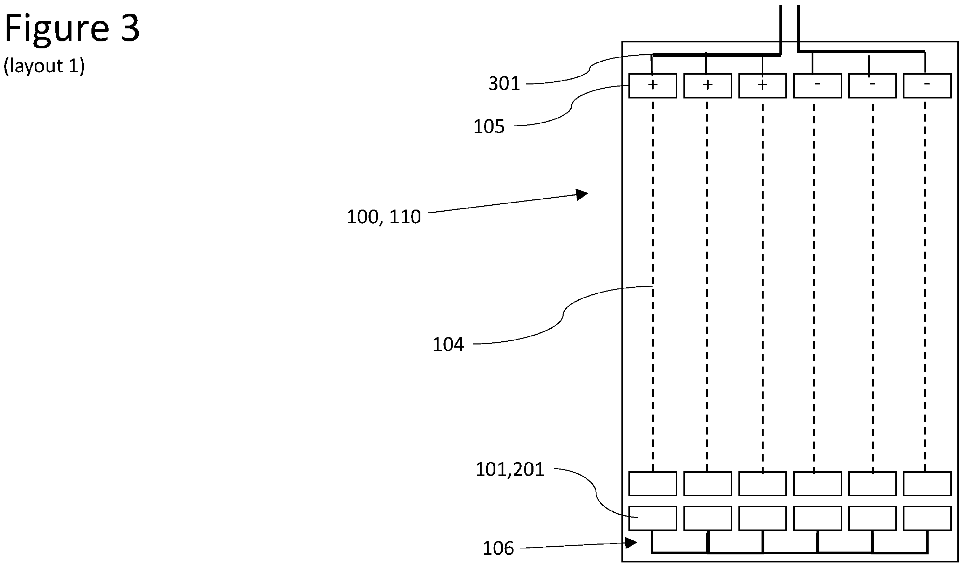

A more cost-effective approach is to connect the three substrings in the solar module in parallel as depicted in Figure 3. This layout is referred to "layout 1" in the current specification. In a parallel connection, it is not important if one of the substrings 104 is shaded because the current can still flow via the other two substrings 104. Since the substring voltage depends logarithmically on the current, the substring voltage does not change significantly during partial shading.

The solar module layout is very simple. Only two rows of cross-connectors 301 are required. The module length is minimized so that the module efficiency is maximized. Only one junction box is required for the two terminals.

The length of the substrings increases to 20 - 24 solar cells 101,201. This would not be possible with a normal bypass diode. Therefore, an electronic control unit, such as a power optimizer or a micro-inverter with a control function may be used to control the substring voltages as described in WO 2021098895 A1. The electrical input characteristic of the control unit is adapted so that it can handle the increased current.

### Description of the invention

It is the task of the invention to present a solar module layout which is highly tolerant against partial shading and which does not require a split module layout in lower and upper half as shown in Figure 2. The assembly effort should not be increased.

A first aspect of the invention discloses a solar module zone of a solar module, the solar module zone comprising an array with rows and columns of solar cells arranged in pairs of substrings along columns of the array, wherein:
- each substring comprises a plurality of solar cells electrically connected in series along the column the substring extends in,
- each pair of substrings comprises two substrings that extend along the columns, particularly adjacent columns, and that are electrically connected in series, and wherein all pairs of substrings are electrically connected in parallel,
- each pair of substrings comprises a positive and a negative end terminal for connecting the pair of substrings to a plus and a minus pole of the solar module, wherein the negative and the positive end terminals of each pair of substrings are located adjacent to each other in an end terminal-connecting portion of the solar module zone, particularly solar module, such that the end terminals of the pairs of substrings form a sequence of end terminals along the columns having a sequence of polarities,
   characterized in that the sequence of polarities of the end terminals comprises at least two changes of polarity of adjacent end terminals.

This particular electrical circuit and arrangement of substrings advantageously enhances the yield of the solar module zone of the solar module for realistic partial shielding scenarios of the solar module zone.

Particularly, the solar module zone comprises an array of solar cells arranged in at least two pairs, particularly three pairs of substrings.

Particularly, each pair of substrings comprises two substrings that extend along the columns of the array.

Particularly, each pair of substrings comprises two substrings that are electrically connected in series within the pair.

The term 'solar module zone' particularly refers to a portion, particularly a rectangular section of the solar module that comprises the components of the solar module zone. As such a solar module may comprise only one, two or a plurality of solar module zones, wherein the solar module zones may comprise identical layouts and/or components.

The solar cells may be silicon-based solar cells.

Particularly, the end terminal-connecting portion of the solar module zone is arranged at a first end portion of the columns. The first end portion can be arranged at an upper or a lower end of the columns of the solar module zone or the solar module.

According to an embodiment of the first aspect of the invention, the sequence of polarity of the end terminals comprises the following sequence of polarity: positive, negative, negative, positive, positive, negative or vice versa. As such, the sequence of polarities of the end terminals may for example comprise three changes of polarity.

According to another embodiment of the first aspect of the invention, the sequence of polarity of the end terminals comprises the following sequence of polarity: positive, negative, positive, negative, positive, negative or vice versa. As such, the sequence of polarities of the end terminals may for example comprise five changes of polarity.

In another embodiment of the first aspect of the invention, the substrings of each pair of substrings are electrically interconnected in an interconnection portion of the array opposite of the end terminal-connecting portion. Particularly, the interconnection portion of the array is arranged at a second end portion of the columns.

According to yet another embodiment of the first aspect of the invention, some or all pairs of substrings are mutually interconnected at the interconnection portions of the array, forming an electrical circuit with some or all substrings with positive end terminals interconnected in parallel and being serially connected to some or all substrings with negative end terminals that are interconnected in parallel.

In a preferred embodiment of the first aspect of the invention, the array of solar cells of the solar module zone consists of exactly three pairs of substrings.

In another embodiment of the first aspect of the invention, the solar module zone comprises electrical connections such as solder joints arranged and configured to connect the positive end terminals to the plus pole and the negative end terminals to the minus pole.

According to yet another embodiment of the first aspect of the invention, the solar module zone comprises an electrical insulator arranged and configured such that the insulator electrically insulates the electrical connections for connecting the positive end terminals to the plus pole from the electrical connections for connecting the negative end terminals to the minus pole.

Preferably, the insulator is at least partially arranged between the electrical connections for connecting the positive end terminals to the plus pole from the electrical connections for connecting the negative end terminals to the minus pole so as to separate and insulate the respective electrical connections from each other.

The insulator may be coated with a conductive layer on two opposite surfaces of the insulator, such that the respective conductive layer becomes part of the respective electrical connection.

As such, the insulator or the insulator coated with a conductive layer may be or may be comprised by a printed circuit board or the like.

In another embodiment of the first aspect of the invention, each substring comprises between 10 and 30 solar cells, particularly between 20 and 24 solar cells.

A second aspect of the invention relates to a solar module, particularly configured for generating a nominal power of at least 300 W, comprising one, two or more solar module zones according to one of the preceding claims. For example, multiple solar module zones of solar module may be electrically connected in series or in parallel.

In an embodiment of the second aspect of the invention, the solar module is connected to and/or comprises a voltage controller configured to control, particularly to limit a voltage between the plus and the minus pole.

According to another embodiment of the second aspect of the invention, the solar module is connected to and/or comprises a voltage converter, particularly a DC-DC voltage converter configured to increase the voltage between the plus and minus pole, such that an electrical current produced by the solar module is reduced.

In yet another embodiment of the second aspect of the invention, the solar module is connected to and/or comprises an inverter configured to convert the voltage between the plus and minus pole into an alternating voltage, particularly wherein the inverter is a micro-inverter, particularly wherein the inverter comprises the voltage converter, particularly wherein the voltage provided to the inverter is provided from the voltage converter.

A third aspect of the invention relates to a photovoltaic (PV) system comprising one or more solar modules. Particularly, multiple solar modules of the photovoltaic system may each comprise their own electronic circuit but they may also be mutually electrically connected in series or in parallel.

The photovoltaic system may comprise a voltage controller system with one or more voltage controllers arranged and configured such that the respective voltages between the plus poles and the minus poles of the respective solar modules can be controlled, particularly limited, by the voltage controller system.

Particularly, exemplary embodiments are described below in conjunction with the Figures. The Figures are appended to the claims and are accompanied by text explaining individual features of the shown embodiments and aspects of the present invention. Each individual feature shown in the Figures and/or mentioned in the text of the Figures may be incorporated (also in an isolated fashion) into a claim relating to the present invention.

### Drawings

- Figure 1:: schematic drawing of a solar module consisting of solar cells, which are typically grouped into three substrings. Each substring is connected to a bypass diode in an anti-parallel fashion.
- Figure 2:: schematic drawing of a solar module with half-cut solar cells.
- Figure 3:: schematic drawing of a solar module with half-cut solar cells that are interconnected to three parallel substrings.
- Figure 4:: schematic drawing of a solar module with half-cut solar cells that are interconnected to three parallel substrings. The substrings are arranged in an alternating pattern. Each substring is independent from the other two substrings.
- Figure 5:: schematic drawing of a solar module with half-cut solar cells that are interconnected to three parallel substrings. The substrings are arranged in an alternating pattern and have a center interconnection at the bottom of the solar module.
- Figure 6:: printed circuit board with integrated 3D functionality to connect cross connectors of equal polarity to a common terminal.
- Figure 7:: Comparison of power output of different module layouts in different shading scenarios.
- Figure 8:: schematic drawing of a solar module comprising two identical solar module zones, wherein the solar module zone corresponds to the one shown in Figure 5.

Figures 1 to 3 depict different arrangements of solar cells 101,201 within solar module zones 110 or solar modules 100 and their corresponding electrical circuits, as described above and known from the prior art.

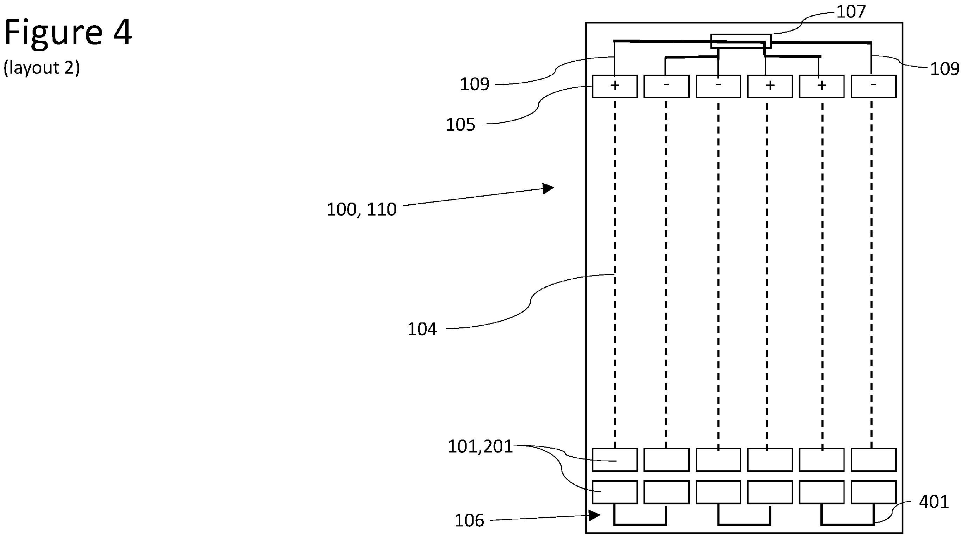

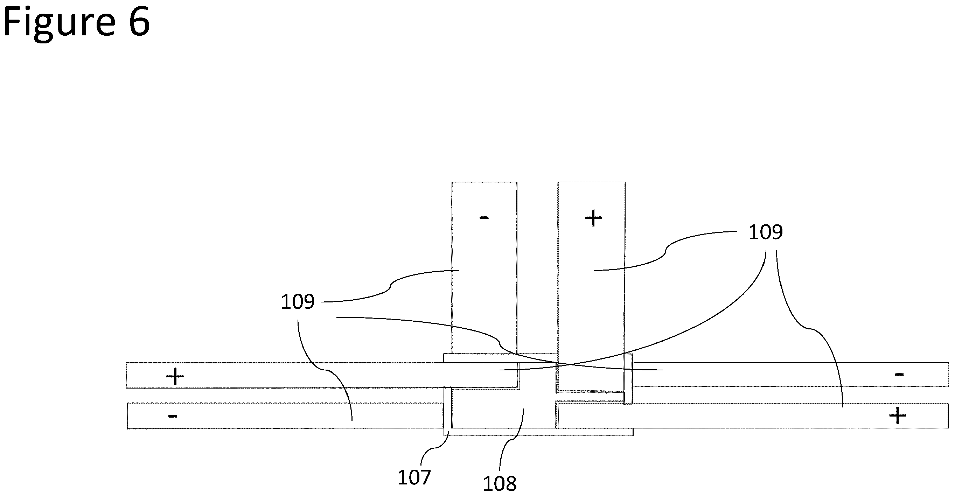

Figure 4 shows a first example embodiment for a solar module 100 comprising one solar module 110 zone according to the invention. The solar module zone 110 comprises six substrings 104 arranged in adjacent columns that each comprise solar cells 101,201 that are electrically connected in series. For example, each substring 104 can comprise 20-24 solar cells 101,201. Each substring 104 comprises a positive or negative end terminal 105 that is connected or may be connected to a plus or minus pole of the solar module 100 via electrical connections 109, such as solder joints. In an interconnecting portion 106 of the solar module zone 110 or the solar module 100 arranged opposite of the end terminals 105, adjacent substrings 104 are interconnected by short cross-connectors 401, such that next three pairs of substrings 106 are arranged next to each other, wherein each pair comprises one substring 106 connected to the plus pole and one substring 106 connected to the minus pole of the solar module 100. As such, the resulting electrical circuit comprises three pairs of substrings connected in parallel. On top of the end terminals 105, the solar module 100 or the solar module zone 110 comprises an insulator 107 arranged and configured to separate the electrical connections 109 connecting the positive end terminals with the plus pole from the electrical connections 109 connecting the negative end terminals with the minus pole. An exemplary embodiment for the insulator is depicted in Figure 6.

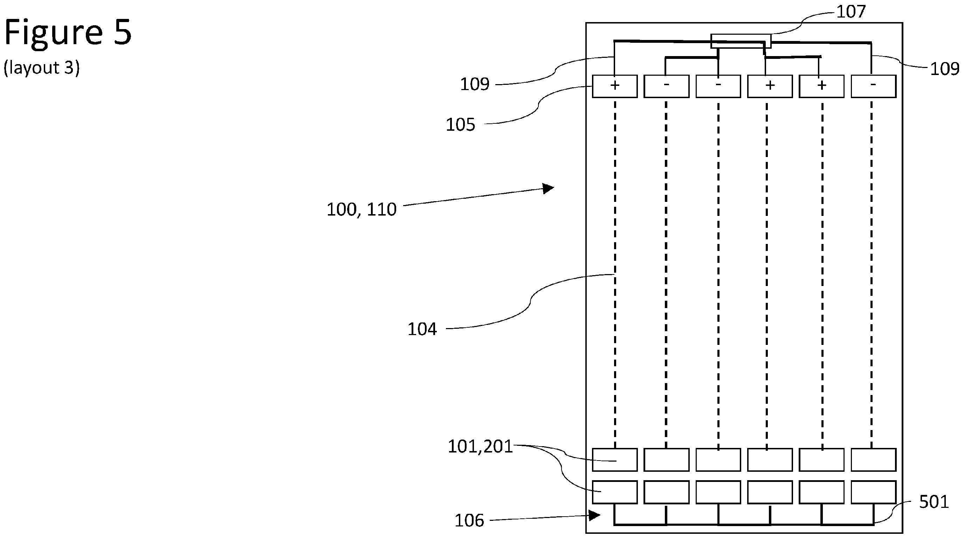

Figure 5 shows a second example embodiment for a solar module 100 comprising one solar module 110 zone. The arrangement of the substrings 104 with their positive and negative end terminals coincides with the one shown in Figure 4. However, in contrast to the first example embodiment shown in Figure 4, the substrings 104 of the second example embodiment shown here in Figure 5 are all mutually electrically interconnected by a long cross-connector 501 in the interconnecting portion 106 of the solar module zone 110 or the solar module 100. As such, the resulting electrical circuit comprises three substrings connected to the plus pole in parallel that are serially connected to three substrings connected to the minus pole in parallel.

At the top of the solar module 100 opposite of the interconnecting portion 106, two different electrical connections 109 are required because of the different polarities of the substrings, as can be seen in Figure 4 and Figure 5. To connect the two electrical connections 109 to the plus and the minus pole while keeping the effective area covered by solar cells 101,201 as high as possible, an insulator 107 is used to achieve a crossing of the electrical connections 109 leading to the minus pole and the ones leading to the plus pole. To facilitate the connection of the electrical connections 109 with equal polarity to a common pole without resulting in a shortcut to the electrical connections 109 of opposite polarity, Figure 6 depicts an arrangement comprising a printed circuit board (PCB), called X-connector PCB. This PCB can be a very thin PCB with layer widths in the micron or sub-micron range and/or a rigid or flexible PCB. The PCB comprises an insulating layer forming an insulator 107 between the electrical connections 109 leading to the plus pole from the ones leading to the minus pole. The insulating layer can be arranged between two conductive layers 108 comprised by the PCB, such that the conductive layer 108 become part of the respective electrical connection 109, as shown in Figure 6. In the top view shown in Figure 6, only the conductive layer 108 being part of the positive electrical connection 109 on top of the PCB can be seen, while the negative electrical connection 109 runs below the insulating layer. To avoid browning effects of the lamination foil of the module. the copper layer in the PCB may be coated, for example with a thin layer of gold, nickel or tin or with another suitable protection coating.

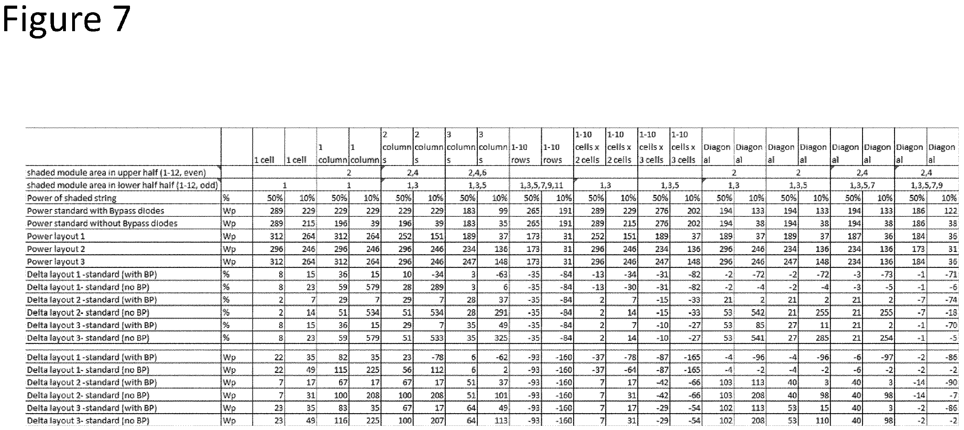

Figure 7 compares the simulated performance of different solar modules with different layouts in different partial shading situations. All solar modules have 120 half-cut solar cells 201. The solar modules 100 are controlled by power optimizers or micro-inverters, so that the other solar modules 100 in the PV system have no impact on the performance of each solar module. The standard layout refers to Figure 2. "Layout 1" refers to Figure 3. "Layout 2" refers to Figure 4, wherein all layouts comprised by the Figures 1 to 4 correspond to solar module zones 110 or solar modules 100 according to the prior art.

The standard layout has bypass diodes 103 which are configured to conduct ("with BP") or not to conduct ("w/o BP"). The other layouts do not have bypass diodes 103 to save cost and because they would not improve the performance.

The analysis considers situations where one or more solar cells 101,201 in the solar module 100 are shaded by 50 % or 90 % (ie. the power is reduced to 10 % of a predetermined value).

The scenarios considered in the simulations are:
- 1 cell: only 1 solar cell 201 in the solar module 100 is partially shaded
- 1 column: all 20 solar cells 201 in the one solar module column are shaded
- 2 columns: all 40 solar cells 201 of two adjacent columns are shaded
- 3 columns: all 60 solar cells 201 of 3 adjacent columns are shaded
- 1 row: 1 row of solar cells 201 is shaded
- 2 half-columns in bottom half are shaded
- 3 half-columns in bottom half are shaded
- Different diagonals

As can be seen in Figure 4, layout 1 performs well when single solar cells 201 or columns are shaded. However, as soon as rows of cells 201 or diagonals are shaded, the standard layout performs better because of the two independent lower and upper module zones 110.

A much better performance can be obtained when arranging the direction of the substrings 104 in a quasi-alternating pattern as shown in Figure 4. While in layout 1, the pattern of the substrings 104 is "+++---‴ in layout 2, the pattern is "+--++-". Since shading mostly originates from outside the solar modules 100, this approach makes the layout much more robust in partial shading situations. Let's assume, the two columns from the left are shaded. Each solar cell 201 delivers a current of 5 A. Then, in layout 1, the current would be reduced from 15 A to 5 A. In layout 2, the current would only be reduced from 15 A to 10 A because column 1 and 2 belong to the same substring 104.

However, there are situations where layout 1 outperforms layout 2. This is because in layout 2, the three pairs of substrings 104 are completely independent and the current cannot be distributed to the other pairs of substrings 104 after one substring length.

To solve this problem, layout 3, which is displayed in Figure 5, introduces an interconnection of all three pairs of substrings 104 in the interconnecting portion 106 of the solar module 100 or the solar module zone 110. Instead of three short cross connectors 401 at the bottom of the module it uses one long cross connector 501.

As the table in Figure 7 clearly demonstrates, layout 3 has by far the best performance in most shading situations. Only when complete rows are shaded, the standard layout is superior.

In fact, such row-shading situations are pretty rare. Most shading scenarios concern object next to a solar module 100 mounted in portrait orientation, such as trees, dormers, or chimneys, i.e. The shape of the shade is rather in a columnar format. On flat roofs, a popular way of mounting solar modules 100 is in rows of modules in landscape orientation. The solar modules 100 are tilted in 10-15° so that rows will shade each other when the sun is relatively low, thereby also causing a columnar shade on the modules.

Depending on the installation conditions, the energy yield of a PV system 111 can be increased significantly when using solar modules 100 with layout 3 rather than solar modules 100 with standard layout.

Another advantage of the alternating substrings 104 is the reduced resistive losses in the cross connectors. In layout 1, the current of the three substrings 104 adds up to 15 A, so the resistive losses can be substantial. In layout 3 on the other hand, the currents of alternating polarity cancel each other out. Therefore, the losses in the cross connectors are reduced significantly.

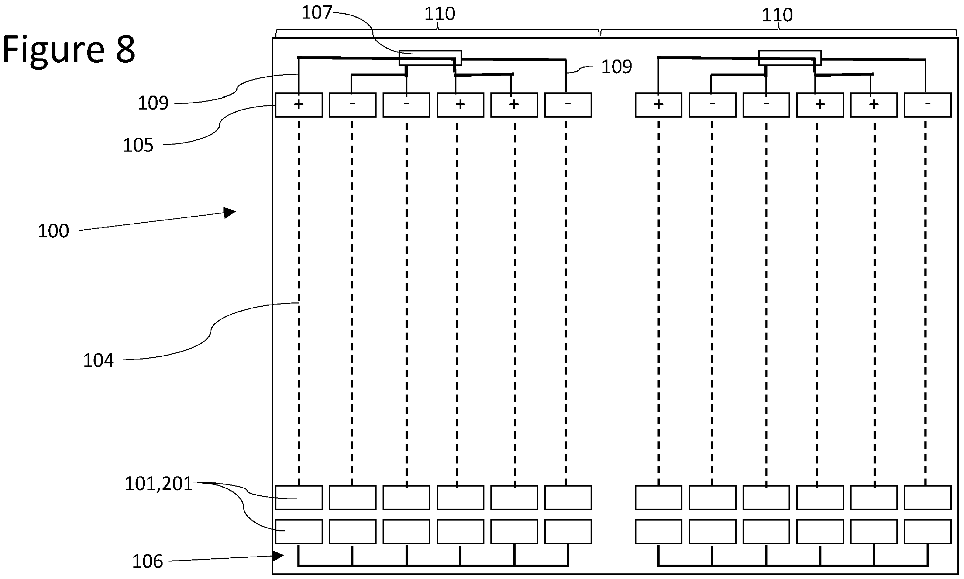

Figure 8 shows an exemplary embodiment of a solar module 100 comprising two solar module zones 110. In this example, the solar module zones 110 are identical and correspond to the one shown in Figure 5. Within one solar module 100, the solar module zones 110 may be electrically connected in series or in parallel (not shown).

### List of reference signs

- 100: solar module
- 101: solar cell
- 102: string
- 103: bypass diode
- 104: substring
- 105: end terminal
- 106: interconnecting portion
- 107: electrical insulator
- 108: conductive layer
- 109: electrical connection
- 110: solar module zone
- 111: photovoltaic system
- 201: half-cut solar cell
- 301: cross-connector
- 401: short cross-connector
- 501: long cross-connector

### Prior Art References

EP 3799245 A
WO 2021098895 A1

## Claims

1. A solar module zone (110) of a solar module (100), the solar module zone (110) comprising an array of solar cells (101,201) arranged in pairs of substrings (104) along columns of the array, wherein
- each substring (104) comprises a plurality of solar cells (101,201) electrically connected in series along the column the substring (104) extends in,
- each pair of substrings (104) comprises two substrings (104) that extend along the columns, particularly adjacent columns, and that are electrically connected in series, and wherein all pairs of substrings (104) are electrically connected in parallel,
- each pair of substrings (104) comprises a positive and a negative end terminal (105) for connecting the pair of substrings (104) to a plus and a minus pole of the solar module (100), wherein the negative and the positive end terminals (105) of each pair of substrings (104) are located adjacent to each other in an end terminal-connecting portion of the solar module zone(110), particularly solar module (100), such that the end terminals (105) of the pairs of substrings (104) form a sequence of end terminals (105) along the columns having a sequence of polarities,
**characterized in that** the sequence of polarities of the end terminals (105) comprises at least two changes of polarity of adjacent end terminals (105).

2. The solar module zone (110) according to claim 1, wherein the sequence of polarity of the end terminals (105) comprises the following sequence of polarity: positive, negative, negative, positive, positive, negative or vice versa.

3. The solar module zone (110) according to claim 1 or 2, wherein the sequence of polarity of the end terminals (105) comprises the following sequence of polarity: positive, negative, positive, negative, positive, negative or vice versa.

4. The solar module zone (110) according to any of the preceding claims, wherein the substrings (104) of each pair of substrings (104) are electrically interconnected in an interconnection portion (106) of the array opposite of the end terminal-connecting portion.

5. The solar module zone (110) according 4, wherein some or all pairs of substrings (104) are mutually interconnected at the interconnection portion (106) of the array, forming an electrical circuit with some or all substrings (104) with positive end terminals (105) interconnected in parallel and being serially connected to some or all substrings (104) with negative end terminals (105) that are interconnected in parallel.

6. The solar module zone (110) according to any of the preceding claims, wherein the array of solar cells (101) of the solar module zone (110) consists of exactly three pairs of substrings (104).

7. The solar module zone (110) according to one of the preceding claims, comprising electrical connections (109) such as solder joints arranged and configured to connect the positive end terminals (110) to the plus pole and the negative end terminals (110) to the minus pole.

8. The solar module zone (110) according to claim 7, further comprising an electrical insulator (107) arranged and configured such that the insulator (107) electrically insulates the electrical connections (109) for connecting the positive end terminals (105) to the plus pole from the electrical connections (109) for connecting the negative end terminals (105) to the minus pole.

9. The solar module zone (110) according to claim 8, wherein the insulator (107) is at least partially arranged between the electrical connections (109) for connecting the positive end terminals (105) to the plus pole from the electrical connections (109) for connecting the negative end terminals (105) to the minus pole so as to separate and insulate the respective electrical connections (109) from each other.

10. The solar module zone (110) according to claim 9, wherein the insulator (107) is coated with a conductive layer (108) on two opposite surfaces of the insulator (107), such that the respective conductive layer (108) becomes part of the respective electrical connection (109).

11. A solar module (100), particularly configured for generating a nominal power of at least 300 W, comprising one, two or more solar module zones (110) according to one of the preceding claims.

12. The solar module (100) according to claim 11, wherein the solar module (100) is connected to and/or comprises a voltage controller configured to control, particularly to limit a voltage between the plus and the minus pole.

13. The solar module (100) according to claim 12, wherein the solar module (100) is connected to and/or comprises a voltage converter, particularly a DC-DC voltage converter configured to increase the voltage between the plus and minus pole, such that an electrical current produced by the solar module (100) is reduced.

14. The solar module (100) according to any of the claims 12 to 14, wherein the solar module (100) is connected to and/or comprises an inverter configured to convert the voltage between the plus and minus pole into an alternating voltage, particularly wherein the inverter is a micro-inverter, particularly wherein the inverter comprises the voltage converter, particularly wherein the voltage provided to the inverter is provided from the voltage converter.

15. A photovoltaic system (111) comprising one or more solar modules (100) according to one of the preceding claims as well as a voltage controller system with one or more voltage controllers arranged and configured such that the respective voltages between the plus poles and the minus poles of the respective solar modules (100) can be controlled, particularly limited, by the voltage controller system.
